# FASCICULE DE BREVET EUROPEEN

(11) **EP 2 750 185 B1**
(45) Date de publication et mention de la délivrance du brevet: **30.09.2015**
(21) Numéro de dépôt: 13199510.2
(22) Date de dépôt: 24.12.2013
(51) Int. Cl.: H01L 21/768, H01L 23/00, H01L 23/31, H01L 23/48

(54) **Procédé amélioré de réalisation d'une structure de reprise de contact**
Verbessertes Verfahren zur Erzeugung einer Kontaktstruktur
Improved method for manufacturing a contact structure

(30) Priorité: 27.12.2012 FR 1262851
(43) Date de publication de la demande: 02.07.2014
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: Colonna, Jean-Philippe, 38700 Corenc (FR); Aumont, Christophe, 38660 Le Touvet (FR); Landis, Stéfan, 38210 Tullins (FR)
(74) Mandataire: Ilgart, Jean-Christophe

(56) Documents cités:
- WO-A2-03/030252
- WO-A2-2008/005087
- JP-A- 2009 226 762
- US-A1- 2006 278 979
- US-A1- 2009 302 484
- US-A1- 2010 102 426

## Description

### DOMAINE TECHNIQUE

La présente invention est relative au domaine de la microélectronique et/ou nanoélectronique et des microsystèmes et/ou nano-systèmes, et concerne en particulier celui de la réalisation de structures de reprises de contact.

Elle s'applique plus généralement à la réalisation de structures conductrices formées sur un support et entourées de moyens d'isolation et d'absorption de contraintes formés dans une couche de matériau diélectrique.

### ÉTAT DE LA TECHNIQUE ANTÉRIEURE

Pour réaliser des dispositifs électroniques qualifiés de « 3D », comprenant une pluralité de substrats ou de composants ou de puces empilé(e)s, il est connu de mettre en oeuvre des structures d'interconnexion sous forme de vias dits « TSV » (TSV pour « Through Silicon Vias ») formées d'un élément conducteur traversant l'épaisseur d'un ou plusieurs substrats ou d'une ou plusieurs puces. Les vias TSV permettent de réaliser une connexion entre un élément situé sur une face appelée « face avant » ou du côté de la face avant d'un substrat et un autre élément situé sur une autre face appelée « face arrière » ou du côté de la face arrière dudit substrat.

Sur la face d'un substrat par laquelle un via TSV débouche, on réalise généralement une structure comprenant une zone conductrice s'étendant le long de cette face, que l'on appelle communément reprise de contact.

Dans ce type de structure, des contraintes dues à une différence de coefficient de dilatation thermique CTE entre les différents matériaux utilisés, notamment le cuivre et le silicium, peuvent être générées.

Pour palier ce problème, il est connu de prévoir d'encapsuler les zones de reprises de contact à l'aide d'une couche d'absorption de contraintes.

Une telle couche peut être également utilisée pour permettre d'absorber des contraintes mécaniques générées notamment lors de l'assemblage de puces, en particulier si on utilise une technique de thermo-compression.

Il se pose le problème de trouver un nouveau procédé de réalisation de structure de reprise de contact.

Le document WO 03/030252 A2 décrit une méthode de fabrication des cavités dans un matériau diélectrique. Les cavités sont dotées de parois inclinées et réalisées par application d'un mode d'embossage.

### EXPOSÉ DE L'INVENTION

La présente invention concerne, selon un premier aspect, un procédé de réalisation d'au moins une structure comprenant une zone conductrice disposée sur une face d'un support, le procédé comprenant des étapes de :
- retrait d'une épaisseur du support au niveau d'une de ces faces de manière à libérer une extrémité d'un élément conducteur traversant au moins partiellement l'épaisseur du support et comportant une extrémité affleurant sur cette face ou dépassant de cette face du support,

a) formation sur cette face du support d'au moins une zone à base de matériau diélectrique sur ledit élément conducteur,
b) formation dans ledit matériau diélectrique d'au moins un premier bloc de matériau diélectrique comportant une première cavité dotée de parois inclinées par rapport à une normale au plan principal dudit support et un fond dévoilant ledit élément conducteur, l'étape b) étant réalisée au moins par application d'un moule d'embossage sur ladite zone de matériau diélectrique,
c) remplissage de ladite cavité à l'aide d'un matériau conducteur de manière à former une zone conductrice dans le prolongement dudit élément conducteur.

La structure réalisée peut être une structure de reprise de contact.

Le premier bloc de matériau diélectrique est prévu notamment pour jouer le rôle d'une zone d'absorption de contraintes générées par ledit matériau conducteur de remplissage à l'étape c). Ce bloc est ainsi à base d'un matériau diélectrique absorbeur de contraintes, par exemple un polymère.

Des pentes inclinées pour la zone conductrice et le bloc de matériau diélectrique formé autour de cette zone permettent de réaliser une répartition efficace des contraintes.

Selon l'invention, l'étape b) est réalisée à l'aide d'un moule d'embossage également appelé « nano-imprint » dont les caractéristiques géométriques sont adaptées pour permettre de réaliser une cavité avec des parois inclinées.

Un tel moule peut permettre de réaliser une cavité avec des parois inclinées selon un angle d'inclinaison plus important qu'avec un procédé utilisant la photolithographie.

Un tel moule peut permettre de réaliser une cavité présentant une embouchure et un fond de section transversale inférieure à celle du fond.

Le moule peut être ainsi sous forme d'un autre support présentant au moins un motif donné faisant saillie, ledit motif donné comportant des flancs inclinés dont l'inclinaison correspond à celle des parois de la cavité. Le motif donné peut en outre présenter une section transversale variable et décroissante de sa base vers son sommet.

La forme du motif donné du moule peut être ainsi complémentaire de celle de ladite première cavité.

Le motif donné du moule peut avoir par exemple une forme conique ou tronconique ou reproduisant une section de pyramide. Ainsi, on peut par exemple réaliser dans le matériau diélectrique une cavité de forme conique ou tronconique ou d'une section de pyramide.

Le motif donné du moule peut avoir une hauteur égale à la profondeur de la première cavité.

Un tel moule peut éventuellement comporter plusieurs motifs ayant des flancs d'inclinaisons différentes.

Ainsi, on peut réaliser dans le matériau diélectrique une ou plusieurs cavités ayant des parois d'inclinaisons différentes.

Selon une possibilité de mise en oeuvre du procédé, le moule utilisé à l'étape b) peut comporter des motifs adaptés pour imprimer en une seule étape plusieurs cavités de profondeurs et/ou comportant des flancs d'inclinaisons différentes.

Un tel moule peut ainsi comporter plusieurs motifs ayant des flancs d'inclinaisons différentes et/ou de hauteurs différentes.

La zone conductrice réalisée sur ledit premier élément conducteur peut être destinée à être connectée avec un élément de connexion d'un autre support ou d'une puce disposée en regard de ladite face donnée ou encore à une région conductrice disposée sur ladite face donnée par exemple dans le cas où l'on forme une ou plusieurs lignes de redistribution électriques.

On peut ainsi réaliser une zone conductrice dans le prolongement dudit élément TSV qui se trouve à distance de la face donnée du support et de prévoir une zone de matériau diélectrique d'absorption de contraintes entre cette zone conductrice et la face inférieure du support.

Cela permet de réaliser une reprise de contact dans laquelle les contraintes sont davantage réduites.

Selon une possibilité de mise en oeuvre du procédé dans laquelle à l'étape a), ladite face donnée du support comporte au moins une portion d'un deuxième élément conducteur, l'application du moule à l'étape b) peut être réalisée de sorte qu'au moins un deuxième bloc de matériau diélectrique comporte au moins une deuxième cavité dévoilant ledit deuxième élément conducteur.

Ainsi, l'étape c) de remplissage de ladite autre cavité à l'aide du matériau conducteur peut conduire à la formation d'une autre zone conductrice dans le prolongement dudit deuxième élément conducteur.

Selon une possibilité de mise en oeuvre du procédé, l'application du moule à l'étape b) peut être réalisée de sorte que ledit premier bloc de matériau diélectrique et ledit deuxième bloc de matériau diélectrique appartiennent à une même zone de matériau diélectrique ou sont séparés par un espace vide.

Selon une possibilité de mise en oeuvre du procédé, la première cavité et la deuxième cavité présentent des parties inférieures séparées par ledit matériau diélectrique et des parties supérieures qui communiquent entre elles.

L'application d'un moule permet ainsi de réaliser un gain d'étapes par rapport à une réalisation par photolithographie.

L'application du moule à l'étape b) peut être telle que ledit premier bloc de matériau diélectrique et ledit deuxième bloc de matériau diélectrique ont des dimensions différentes entre eux.

Ledit premier bloc et ledit deuxième bloc de matériau diélectrique peuvent avoir des hauteurs et/ou des épaisseurs et/ou des largeurs différentes.

En fonction de la répartition des contraintes sur le support, on peut prévoir de former des blocs de matériau diélectrique d'épaisseur et/ou de hauteur plus importante aux endroits du support où les contraintes sont plus importantes et de former des blocs de matériau diélectrique d'épaisseur et/ou de hauteur moindre aux endroits du support où les contraintes sont plus faibles, et où l'on cherche à avoir par exemple une densité d'intégration plus importante.

Selon une possibilité de mise en oeuvre du procédé, l'application du moule à l'étape b) peut être telle que ledit premier bloc de matériau diélectrique et ledit deuxième bloc de matériau diélectrique présentent des flancs inclinés par rapport à une normale au plan principal dudit support, l'inclinaison des flancs dudit premier bloc étant différente de celle des flancs dudit deuxième bloc de matériau diélectrique.

De même, l'inclinaison des flancs des blocs de matériau diélectrique peut être adaptée en fonction des contraintes exercées.

Selon une possibilité de mise en oeuvre du procédé, entre l'étape b) et l'étape c) on peut former une couche de germination sur les parois et le fond de ladite cavité, l'étape c) étant réalisée par croissance sur la couche de germination.

L'inclinaison des parois de la cavité peut alors permettre de faciliter la formation de cette couche.

Selon une possibilité de mise en oeuvre du procédé, le moule d'embossage ou de « nano-imprint » peut être sous forme d'un autre support, par exemple une plaque présentant au moins un motif donné faisant saillie sur ledit autre support, ledit motif donné ayant une section transversale décroissante de sa base vers son sommet ainsi que des flancs inclinés par rapport à une normale à un plan principal dudit autre support.

Selon une possibilité de réalisation, le moule d'embossage peut présenter au moins un autre motif faisant saillie, ledit autre motif comportant des flancs d'inclinaison différente de celle des flancs dudit motif donné, et/ou des dimensions différentes de celle dudit motif donné.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1E, illustrent un premier exemple de procédé selon l'invention, de réalisation d'une structure de reprise de contact dans laquelle une zone conductrice à flancs inclinés et qui est formée sur un via TSV est entourée d'une zone de matériau diélectrique absorbeur de contraintes, la zone de matériau diélectrique ayant des flancs inclinés épousant ceux de la zone conductrice ;
- la figure 2 illustre un moule d'embossage pour former des motifs à flancs inclinés dans un matériau diélectrique absorbeur de contraintes au cours d'un procédé suivant l'invention ;
- la figure 3 illustre une structure de reprise de contact obtenue à l'aide d'un procédé selon l'invention ;
- les figures 4A-4E, illustrent une variante du premier exemple de procédé ;
- les figures-5A-5D, illustrent un autre exemple de procédé dans lequel on réalise une reprise de contact sur des vias traversant, la reprise de contact étant formée d'une ligne conductrice horizontale surmontée d'un plot de forme hémisphérique ;
- les figures 6A-6B, illustrent des étapes de réalisation d'une couche de nucléation en vue de la formation d'une zone conductrice surmontant des vias traversant lors de la réalisation d'une structure d'interconnexion suivant l'invention ;
- la figure 7 illustre une structure d'interconnexion comprenant une zone de reprise de contact en face avant d'un substrat et dans laquelle une zone conductrice à flancs inclinés est entourée d'une zone de matériau diélectrique d'absorption de contraintes, la zone de matériau diélectrique ayant des flancs inclinés épousant ceux de la zone conductrice ;
- les figures 8 et 9 illustrent des variantes de réalisation de structures;
- la figure 10 illustre un moule de nano-imprint pour former des motifs d'isolation et d'absorption de contraintes tels que représentés sur la figure 9.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

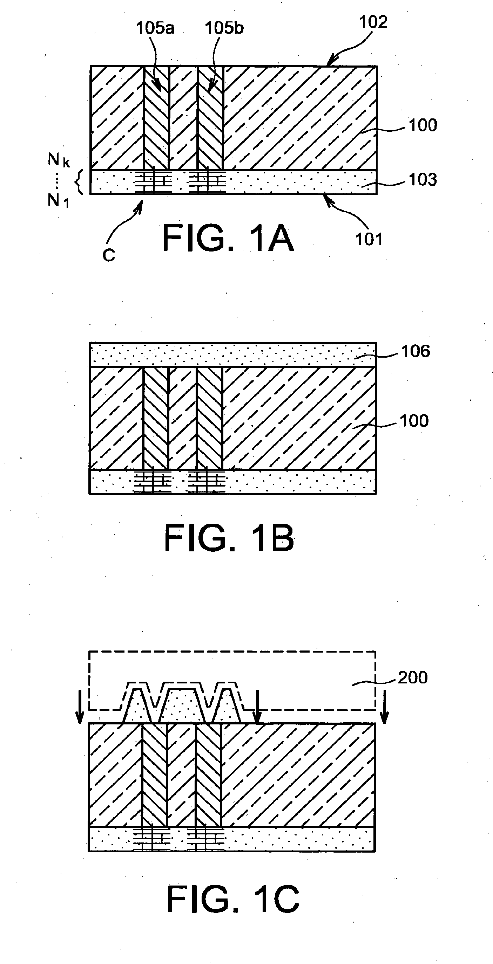

Un premier exemple de procédé, suivant l'invention, de réalisation d'un dispositif microélectronique doté d'une structure de reprise de contact, va à présent être décrit en liaison avec les figures 1A-1E.

Le matériau de départ de ce procédé (figure 1A) peut être un support 100 formé d'un substrat semi-conducteur, par exemple à base de Si, doté d'au moins un circuit C et de niveaux métalliques N₁,...,Nₖ d'interconnexions de composants du circuit disposés dans une couche isolante 103, chaque niveau métallique pouvant comprendre une pluralité de lignes métalliques horizontales, des zones métalliques verticales ou vias étant prévus pour connecter entre eux les lignes métalliques horizontales.

Des éléments conducteurs 105a, 105b communément appelés vias TSV traversent l'épaisseur du substrat 100, et débouchent sur la face inférieure du support également appelée « face arrière » 102 opposée à la face supérieure également appelée « face avant » 101.

Les éléments conducteurs 105a, 105b, sont connectés aux niveaux métalliques d'interconnexion et permettent d'établir une liaison électrique entre des éléments disposés sur la face supérieure 101 et la face inférieure 102 du support 100.

Ensuite, on forme une couche de matériau diélectrique 106 sur la face arrière 102 par exemple par dépôt à la tournette (figure 1B).

Le matériau diélectrique 106 est un matériau prévu pour jouer le rôle d'absorbeur de contraintes (« stress buffer » selon la terminologie anglo-saxonne).

Pour cela, le matériau diélectrique 106 peut être par exemple un matériau polymère.

Le matériau diélectrique 106 peut être en particulier choisi de manière à avoir un module d'Young compris par exemple entre 2 GPa et 60 GPa. Le matériau diélectrique 106 peut être également choisi de manière à avoir un coefficient de dilatation thermique CTE (pour « coefficient of thermal expansion ») faible, par exemple inférieur à 60 ppm.

L'épaisseur de matériau diélectrique 106 déposée peut être comprise par exemple entre 2 µm et 12 µm.

Le matériau diélectrique 106 peut être également un matériau choisi en particulier de manière avoir une stabilité en température élevée, par exemple d'au moins 300 °C.

Le matériau diélectrique 106 peut être également choisi de manière à pouvoir être nettoyé à une température basse, par exemple inférieure à 200°C.

Le matériau diélectrique 106 peut être également choisi de manière à avoir une constante diélectrique par exemple de l'ordre de 3 ou 4.

Le matériau diélectrique 106 peut être également un matériau ayant une température de transition vitreuse Tg inférieure à 160 °C

Le matériau diélectrique 106 peut être également choisi avec un faible facteur de rétrécissement, en particulier inférieur à 10% et un facteur d'élongation important, par exemple supérieur à 20%.

Le matériau diélectrique 106 peut être par exemple un polymère de type de celui disponible sous la référence ALX2010 de la société Asahi Glass Inc. ou de celui disponible sous la référence PBO8930 de la société HD MicroSystems. En variante, le matériau diélectrique 106 peut être un oxyde de silicium déposé par exemple par un procédé d'étalement par centrifugation communément appelé « SOG » (pour « Spin On Glass »).

| | ALX2010 | PBO8930 | SiO₂(SOG) |
|---|---|---|---|
| Module D'Young (GPa) | 2.6-2.7 | 1.8 | 70 |
| Allongement (%) | 20 | 80 | 0 |
| CTE (ppm/°C) | 62 | 80 | 0.5 |
| Contrainte (MPa) | 32 | 25 | -70 |
| Constante diélectrique | 2.6 | 3.1 | 5-6 |

Ensuite (figure 1C), on forme des motifs dans le matériau diélectrique 106 par une technique d'impression, communément appelée embossage ou « imprint » ou nano-imprint », à l'aide d'un moule 200, par exemple à base de Si ou de quartz, doté lui-même de motifs que l'on vient appliquer sur la couche de matériau diélectrique 106 afin de former des motifs complémentaires dans ce matériau 106.

Des fenêtres d'alignement, par exemple sous forme d'ouvertures pratiquées dans le moule peuvent être prévues et mises en regard de marques d'alignement du support 100.

L'application du moule 200 peut être accompagnée d'un apport de chaleur, comme cela est réalisé par exemple dans le document "Imprint of sub 25 nm vias and trenches in polymers" Stephen Y. Chou, Peter R. Krauss, and Preston J. Renstrom Appl. Phys. Lett. 67, 3114 (1995) ou bien réalisé sous rayonnement UV comme cela est réalisé par exemple dans le document "Patterning curved surfaces: Template generation by ion beam proximity lithography and relief transfer by step and flash imprint lithography" P. Ruchhoeft, M. Colburn, B. Choi, H. Nounu, S. Johnson, T. Bailey, S. Damle, M. Stewart, J. Ekerdt, S. V. Sreenivasan, J. C. Wolfe, C. G. Willson, J. Vac. Sci. Technol., Nov/Dec, 2965 (1999).

Les motifs du moule 200 peuvent avoir une taille ou une dimension critique de l'ordre de un ou plusieurs dizaines de nanomètres ou d'une ou de plusieurs centaines de nanomètres ou de plusieurs micromètres.

Cette technique permet ainsi de réaliser des motifs selon une importante gamme de dimensions tout en étant peu couteuse à mettre en oeuvre.

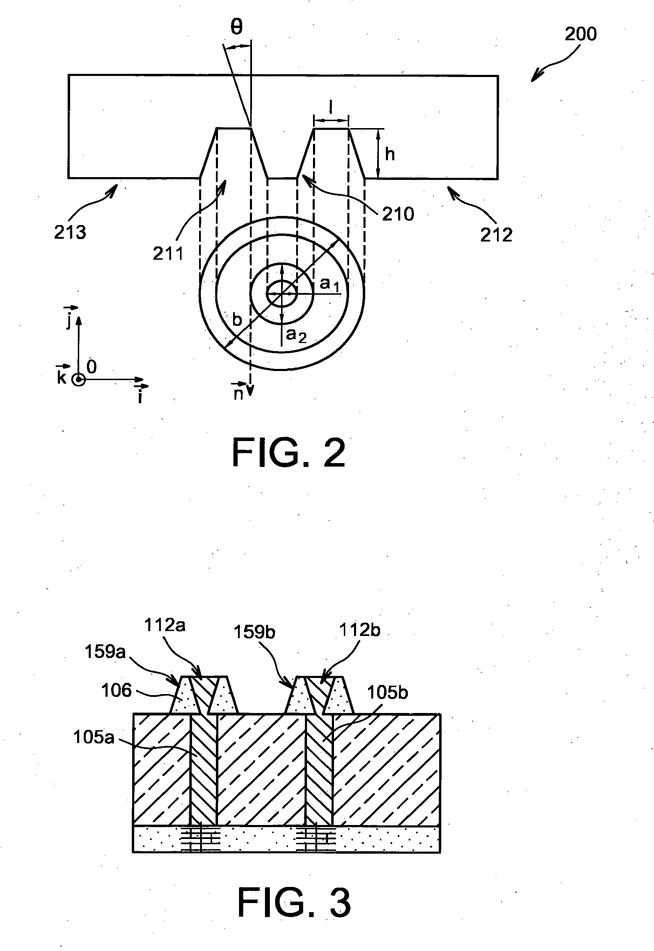

La figure 2 illustre un exemple particulier d'une portion de moule 200 qui peut être sous forme d'une plaque comportant un motif 210 de section transversale (la section transversale étant prise parallèlement au plan [O*; i̅ ; k̅*] du repère orthogonal [O*; i̅ ; j̅ ; k̅* ]), par exemple de forme tronconique ayant des flancs inclinés selon un angle θ non-nul, qui peut être inférieur à 45°, par exemple de l'ordre de 35° par rapport à une normale *̅n̅*̅ au plan principal de la plaque (le plan principal de la plaque étant défini sur la figure 2 comme un plan passant par la plaque et qui est parallèle au plan [O; *̅i̅*̅ ; *̅k̅*̅] du repère orthogonal [O*; i̅ ; j̅ ; k̅*])*.*

Le motif 210 représenté sur la figure 2 peut avoir une hauteur h de l'ordre de plusieurs micromètres, par exemple de l'ordre de 4 µm, une base formant un disque de diamètre a₁ par exemple de l'ordre de 3 µm et un sommet formant un disque de diamètre a₂ par exemple de l'ordre de 6 µm. Le motif 210 de forme tronconique est ici entouré d'une tranchée 211 réalisée dans la plaque 200. Cette tranchée 211 forme un contour fermé, par exemple sous forme d'un anneau circulaire, autour du motif 210 tronconique. Cet anneau peut avoir par exemple un diamètre extérieur de l'ordre de 10 µm. La tranchée 211 est également entourée de blocs 212, 213 de la plaque qui, dans cet exemple, ont une même hauteur que le motif 211.

Un tel moule 200 peut avoir été réalisé par le biais d'une technique de micro-usinage, à l'aide par exemple d'une gravure par une solution de TMAH ou de KOH ou une solution alcaline.

Le moule 200 et l'embossage réalisé à l'aide de ce dernier peuvent être prévus de sorte à former des ouvertures ou cavités 108a, 108b évasées, qui peuvent avoir par exemple une forme tronconique et dévoilent respectivement l'extrémité d'un premier élément conducteur TSV 105a, et d'un deuxième élément conducteur TSV 105b.

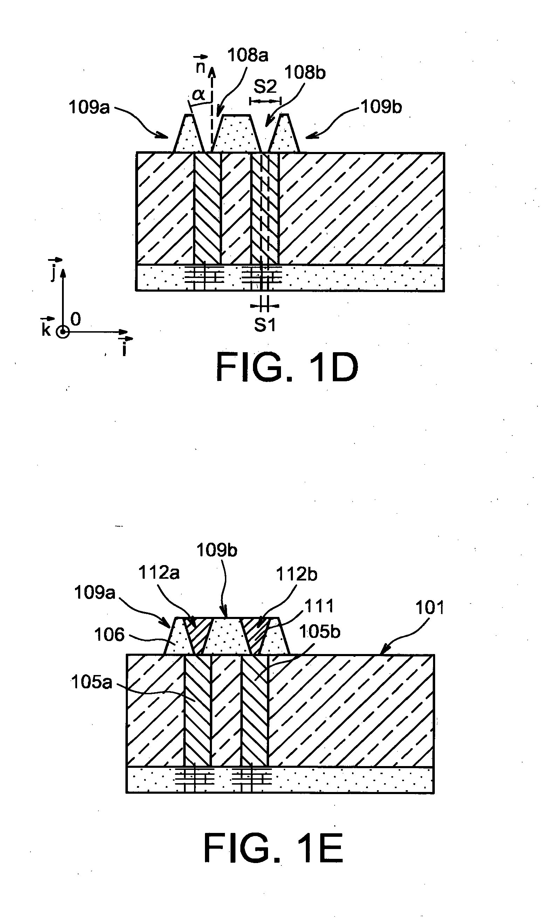

Les cavités 108a, 108b sont définies dans des blocs 109a, 109b du matériau diélectrique 106 et comportent des parois inclinées selon un angle α par rapport à une normale *̅n̅*̅ au plan principal substrat (le plan principal du substrat étant défini sur la figure 1D comme un plan passant par ce dernier et qui est parallèle au plan [O*; i̅ ; k̅*] du repère orthogonal [O*; i̅ ; j̅ ; k̅*])*.* Chaque cavité 108a, 108b comporte une section transversale variable, la section transversale prise au niveau de l'embouchure des cavités étant supérieure à leur section transversale prise au niveau de leur fond.

Au fond des cavités 108a, 108b, des extrémités des éléments conducteurs 105a, 105b TSV sont dévoilées (figure 1D).

On peut ensuite réaliser un retrait de résidus de matériau diélectrique 106 au fond des cavités 108a, 108b et dans des zones de la face inférieure du substrat disposées autour des blocs 105a, 105b. Ce retrait peut être réalisé par gravure sèche, par exemple à l'aide d'un plasma à base de O₂.

Puis, les cavités 108a, 108b sont remplies de matériau conducteur 111 (figure 1E). Ce matériau conducteur 111 peut être métallique et par exemple du cuivre. Une technique adaptée pour ce remplissage est le dépôt auto-catalytique communément appelé « electroless plating ». La configuration des cavités 108a, 108b en particulier la pente de leurs parois, permet d'obtenir un remplissage de meilleur qualité par exemple par rapport à des cavités qui auraient un profil en forme de marche (s).

Dans un cas (non représenté sur les figures 1D-1E) où l'on réalise une croissance de matériau conducteur au moyen d'une électrolyse classique, on peut former, préalablement au remplissage, une couche susceptible de jouer le rôle de barrière de diffusion et de couche de germination. Une telle couche peut, être formée d'un empilement à base de Ti et de Cu par exemple par PVD (pour « Physical Vapor Deposition ») ou CVD (pour « Chemical Vapor Deposition ») tapissant les parois et le fond des cavités 108a, 108b. La pente des parois des cavités 108a, 108b facilite la réalisation d'une telle couche de germination par rapport à des cavités qui comporteraient des parois verticales.

On réalise ainsi sur la face inférieure 101 du support, des zones conductrices 112a, 112b comportant des flancs inclinés par rapport à une normale au plan principal substrat et qui épousent les flancs de blocs 109a, 109b, de matériau diélectrique 106.

De par la forme des blocs 109a, 109b et en particulier l'inclinaison des flancs contre les flancs inclinés des zones conductrices, ainsi que le type de matériau diélectrique 106 à partir duquel ces blocs sont formés, les blocs 109a, 109b, sont prévus pour jouer le rôle d'absorbeurs de contraintes générés par le matériau des zones 112a, 112b. Les zones conductrices 112a, 112b réalisées ont une section transversale variable.

Selon un exemple particulier les zones conductrices 112a, 112b ont une forme évasée qui peut être tronconique.

Dans un cas où l'étape de remplissage des ouvertures 108a, 108b est réalisée de sorte que la couche de germination et le matériau métallique de remplissage dépassent de l'embouchure des ouvertures 108a, 108b, une étape de planarisation (CMP) peut être réalisée pour retirer les matériaux en excès.

Sur la figure 3, une variante de réalisation de la structure d'interconnexion précédemment réalisée est donnée. Les zones conductrices 112a, 112b, surmontant les éléments conducteurs 105a, 105b TSV sont entourées de blocs 159â, 159b de matériau diélectrique polymère disjoints. Ces blocs 159a, 159b ont été réalisés par application d'un moule non représenté comportant un motif que l'on a appliqué à une zone de matériau diélectrique 106 située entre les zones conductrices 112a, 112b. Les blocs 159a, 159b de matériau diélectrique forment chacun un contour fermé autour d'une zone conductrice 112a ou 112b et sont séparés entre eux par un espace vide.

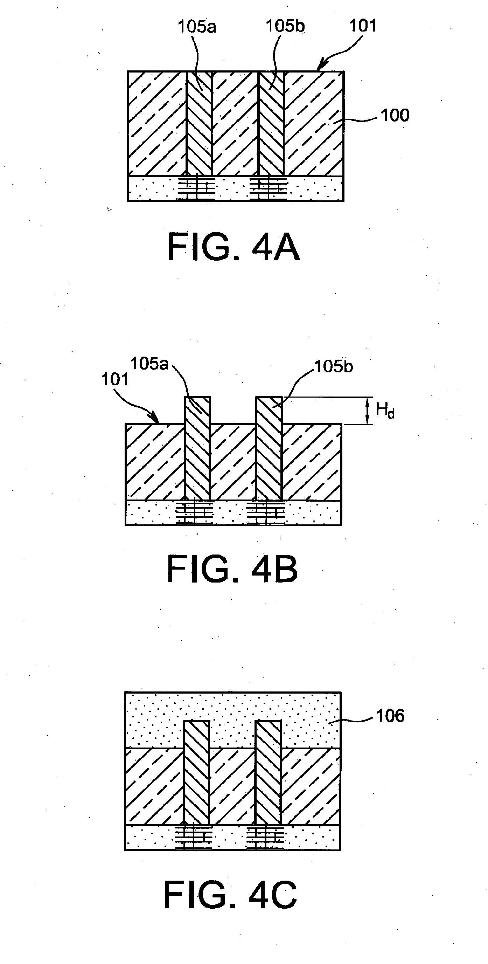

Un autre exemple de réalisation est donné sur les figures 4A-4E.

Ce procédé diffère de celui décrit précédemment en liaison avec les figures 1A-1E, notamment en ce qu'on réalise un retrait d'une épaisseur du substrat 100 au niveau de sa face 101 arrière, de manière à libérer une portion des éléments 105a, 105b TSV qui était entourée du matériau semi-conducteur du substrat 100 (figures 4A-4B). A l'issue de ce retrait, les éléments conducteurs 105a, 105b ont une extrémité qui dépasse de la face inférieure 101 du substrat 100.

Ce retrait peut être réalisé par exemple à l'aide d'une gravure sèche par plasma. Une épaisseur par exemple comprise entre 1 µm et 10 µm peut être retirée, de sorte qu'une extrémité des éléments conducteurs 105a, 105b dépasse de la face inférieure du substrat 100, selon une hauteur H_{d} (mesurée sur la figure 4B dans une direction parallèle au vecteur *̅j̅*̅ du repère orthogonal [O; *i̅ ; j̅ ; k̅*] et prise entre la face inférieure 101 du substrat 100 jusqu'au sommet des éléments conducteurs 105a, 105b, par exemple de l'ordre 2 µm (figure 4B).

On forme ensuite la couche de matériau diélectrique 106, de manière à recouvrir l'extrémité libre des éléments conducteurs 105a, 105b (figure 4C).

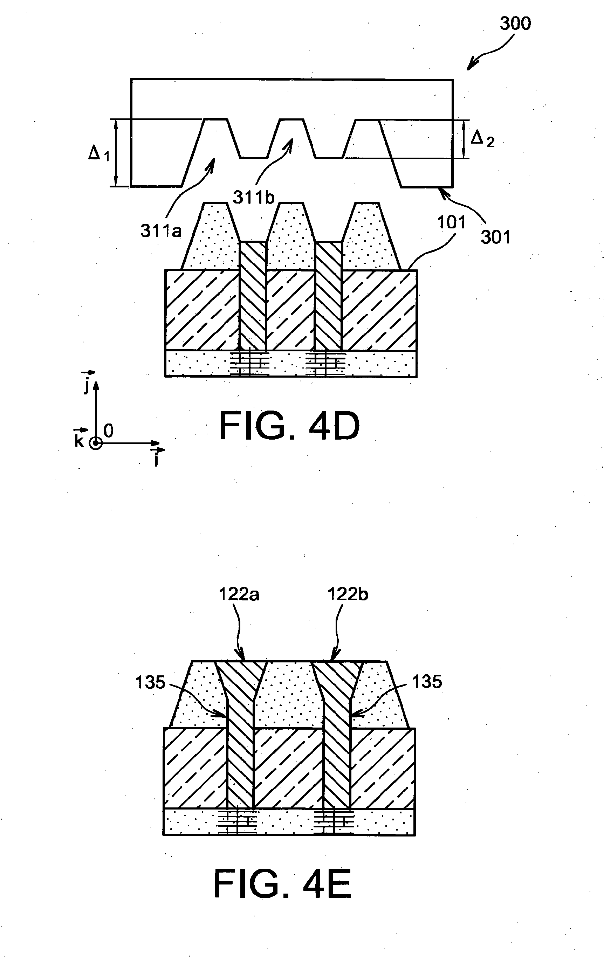

Puis, on réalise des cavités dans cette couche par application d'un moule 300 comportant motifs de hauteurs différentes, en particulier des creux ou tranchées 311a, 311b de profondeurs respectives Δ₁ et Δ₂ différentes que l'on applique contre le matériau diélectrique 106 (les profondeurs Δ₁ et Δ₂ étant mesurées sur la figure 4D dans une direction parallèle au vecteur *̅j̅*̅ du repère orthogonal [O; *i̅; j̅; k̅*]).

Le sommet de l'extrémité des éléments conducteurs 105a, 105b dépassant de la face arrière 101 du substrat 100 peut servir de butée d'arrêt au moule 300 avec lequel l'embossage est réalisé.

L'épaisseur de la couche de matériau diélectrique 106 préalablement déposée, la hauteur Hd de dépassement des éléments conducteurs 105a, 105b ainsi que les profondeurs Δ₁, Δ₂ des motifs 301 du moule, peuvent avoir été prévus de sorte que lorsqu'on applique le moule 300, on dévoile le sommet des éléments conducteurs 105a, 105b (figure 4D).

On remplit ensuite les cavités 108a, 108b réalisées à l'aide d'un matériau métallique tel que du cuivre pour réaliser des zones conductrices 122a, 122b formant des têtes à flancs inclinés par rapport à une normale *̅n̅*̅ au plan principal du support 100, dans le prolongement de l'extrémité des éléments conducteurs 105a, 105b.

Par rapport à une configuration telle qu'illustrée sur les figures 1E et 3, les zones conductrices 122a, 122b sont déportées et situées à distance de la face arrière du substrat 100. Cette configuration permet d'avoir des zones 135 de matériau diélectrique 106 d'absorption de contraintes sous les zones conductrices 122a, 122b, et ainsi de limiter davantage les contraintes générées au sein de la structure d'interconnexion (figure 4E).

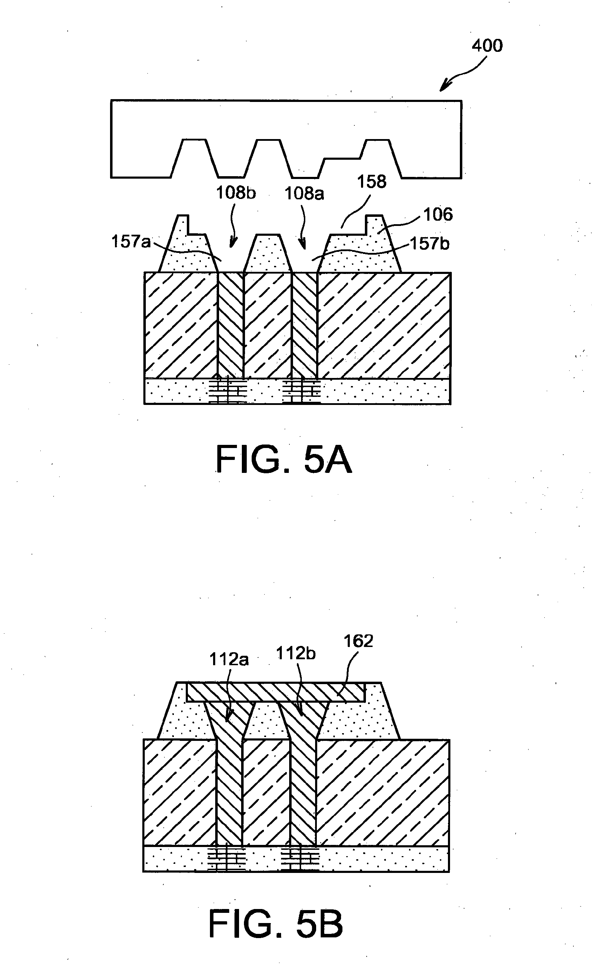

Un autre exemple de procédé suivant l'invention est illustré sur les figures 5A-5D. Ce procédé diffère de celui décrit précédemment en liaison avec les figures 1A-1E, notamment de par l'étape d'embossage.

Cette étape est réalisée à l'aide d'un moule 400 permettant de former des cavités 108a, 108b, dans la couche de matériau diélectrique 106 comportant respectivement une partie inférieure 157a, et une partie inférieure 157b séparées entre elles par le matériau diélectrique 106 et une partie supérieure 158 commune qui surmonte les parties inférieures 157a, 157b et qui est disposée dans leur prolongement (figure 5A).

Ainsi, en une seule étape, on forme par impression à l'aide du moule 400 dans la couche de matériau diélectrique 106, des emplacements pour des zones conductrices dans le prolongement des éléments TSV 105a, 105b, ainsi qu'un emplacement pour une ligne conductrice horizontale.

On réalise un gain de temps et de coût par rapport à un procédé dans lequel on aurait dû utiliser au moins deux étapes de photolithographie pour réaliser de tels motifs dans la couche de matériau diélectrique 106.

Un remplissage des cavités 108a, 108b est ensuite effectué à l'aide d'un matériau métallique tel que du cuivre. Ce remplissage conduit à la formation de zones conductrices 112a, 112b, dans le prolongement des éléments conducteurs 105a, 105b et d'une ligne conductrice 162 horizontale au dessus et dans le prolongement des zones conductrices 112a, 112b (figure 5B).

Puis, sur la ligne conductrice 162 horizontale, on réalise un plot 170 conducteur. Ce plot 170 peut être formé d'une première zone conductrice 164, par exemple à base de cuivre, sur laquelle on empile une deuxième zone conductrice 166 formée sur la première zone conductrice 164 et qui peut être à base d'un alliage de brasure, par exemple à base de SnAg.

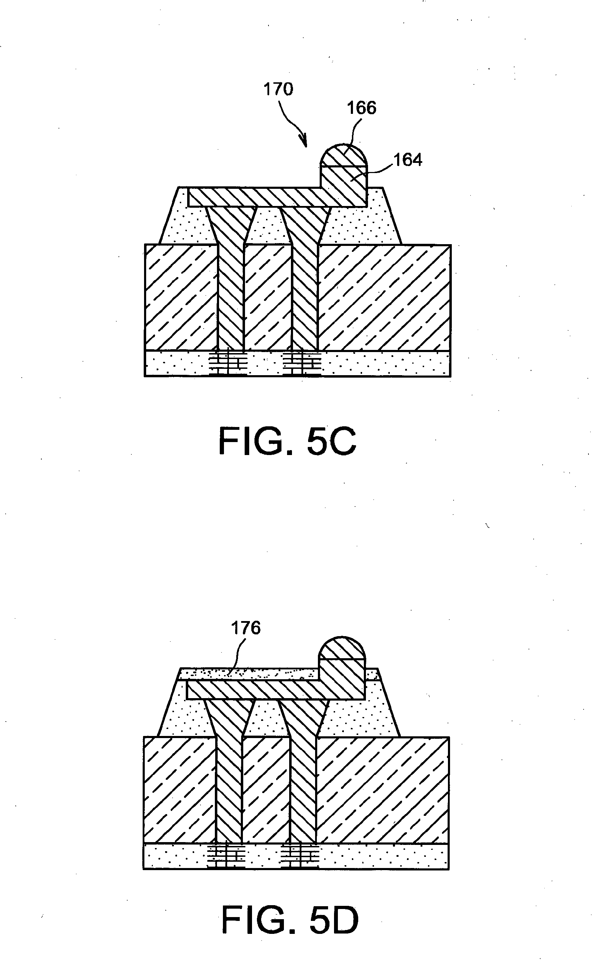

Ce bi-couches peut être formé par électrolyse. Une étape de recuit à l'aide d'un four peut permettre de conférer une forme hémisphérique à la deuxième zone conductrice 166 (figure 5C).

Ensuite, on peut éventuellement recouvrir la ligne conductrice 162 d'un matériau diélectrique 176, par exemple un matériau polymère du même type que celui utilisé pour former la couche diélectrique 106. La ligne conductrice 162 est ainsi encapsulée (figure 5D).

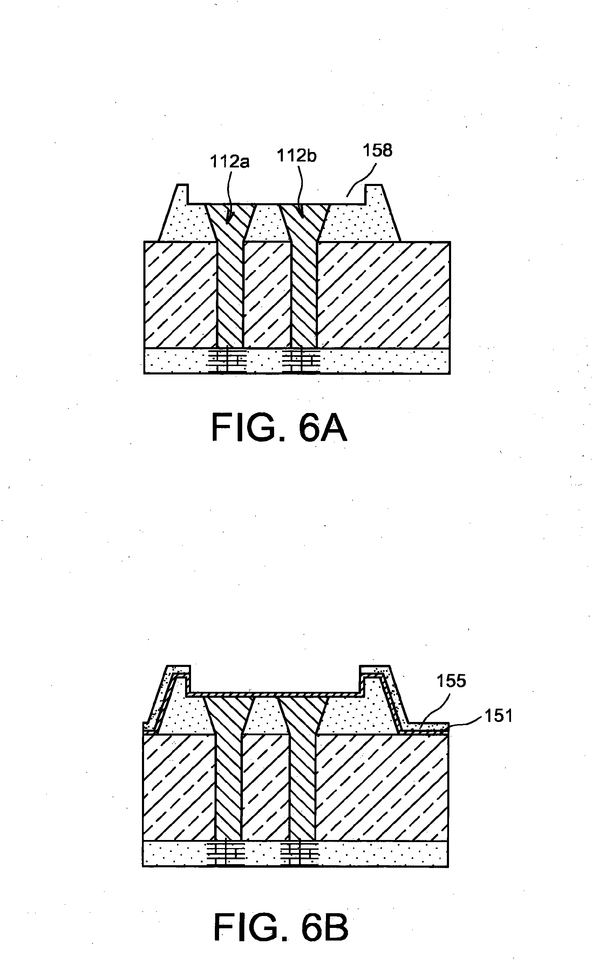

Selon une mise en oeuvre particulière de l'exemple de procédé précédemment décrit, et en particulier de la ligne conductrice 162 horizontale, on peut effectuer tout d'abord le remplissage des cavités 108a, 108b à l'aide d'un matériau métallique, de manière à former les zones conductrices 112a, 112b, tandis que la partie supérieure 158 n'est pas remplie (figure 6A).

Ensuite, on forme une couche de germination 151, puis un masquage 155 de résine dévoilant la tranchée 158 (figure 6B). Des étapes (non représentées) de dépôt électro-chimique (ECD) de métal, de retrait du masquage de résine 155, puis éventuellement de planarisation ou de polissage mécano-chimique (CMP) de manière à retirer le métal en excès, avec arrêt sur la couche de diélectrique peuvent être alors réalisées pour former la ligne conductrice 162.

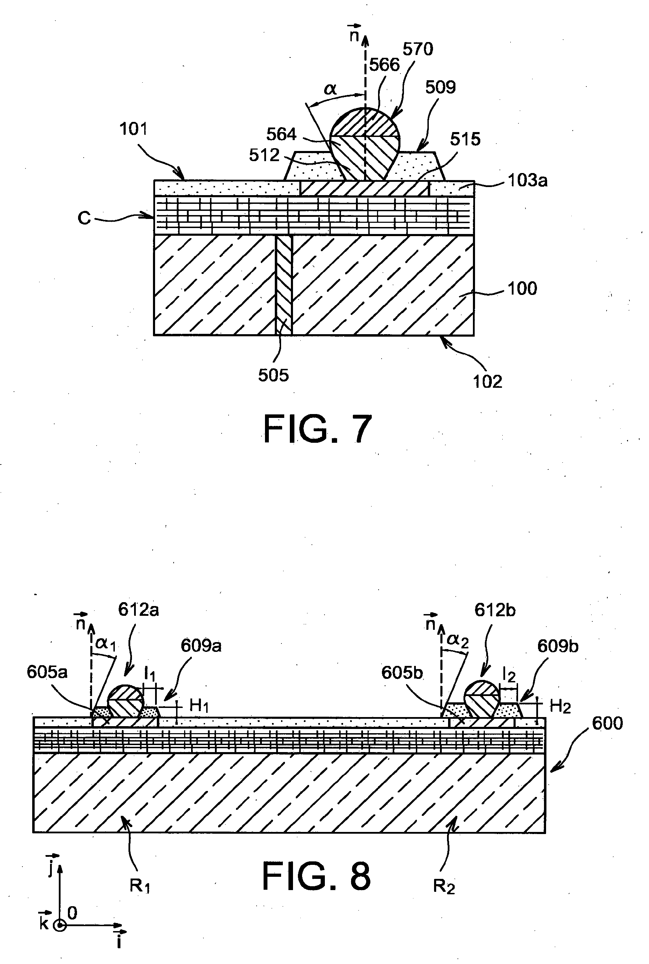

Une variante de structure est donnée sur la figure 7.

Cette structure est formée sur un support comprenant un substrat 100 semi-conducteur doté sur sa face supérieure, de composants formant un circuit C et de niveaux métalliques N₁,...,Nₖ d'interconnexions des composants.

Un élément d'interconnexion 505 TSV traverse l'épaisseur du substrat 100 et permet d'établir une connexion électrique entre le circuit situé sur la face avant 101 du support et la face arrière 102 de ce dernier.

Un plot conducteur 515, par exemple à base d'aluminium est disposé sur la face avant 101 du support au dessus des niveaux métallique d'interconnexion. Ce plot conducteur est connecté au circuit C et est surmonté d'un bloc 509 d'absorption de contraintes à base du matériau diélectrique 106. Le bloc 509 comporte une ouverture dont les parois sont inclinées par rapport à une normale *̅n̅*̅ au plan principal substrat selon un angle α.

Cette zone conductrice 512 peut avoir été réalisée à partir d'une couche de nucléation tapissant les parois et le fond d'une cavité puis croissance de matériau métallique tel que du cuivre de manière à remplir cette cavité. La zone conductrice 512 comporte ainsi des flancs inclinés épousant ceux du bloc 509 de matériau diélectrique 106. La zone conductrice 512 est également surmontée d'un empilement formé d'une zone métallique 564, par exemple à base de cuivre, sur laquelle une autre zone 566 ayant une forme hémisphérique ou de bosse est réalisée.

Une variante de réalisation de reprises de contact est donnée sur la figure 8.

Pour cette variante, des blocs 609a, 609b d'isolation et de réduction de contrainte, à base de matériau diélectrique et ayant différentes formes et différentes tailles sont formées autour de zones conductrices 612a, 612b sur une même face d'un support 600. Les blocs 609a, 609b sont suivant leur formes et de leurs dimensions en fonction de la répartition des contraintes sur le support 600, qui peut être par exemple une puce comportant plusieurs niveaux métalliques d'interconnexion.

Les blocs 609a, 609b peuvent être à base de matériau polymère ou de SiO₂ et ont été formés par embossage à l'aide d'un moule, selon une technique semblable à celle décrite précédemment en liaison avec la figure 1C.

Les zones conductrices 612a, 612b sont, dans cet exemple, réalisés sur des éléments conducteurs 605a, 605b sous forme de plots connectés aux niveaux métalliques d'interconnexion. Les zones conductrices 612a, 612b comportent une portion inférieure ayant une section transversale variable qui augmente de la base vers son sommet et épouse la forme des blocs 609a, 609b.

Les zones conductrices 612a, 612b comportent également une portion supérieure hémisphérique reposant sur la portion inférieure.

Dans une zone R₂ située en périphérie de la puce dans laquelle les contraintes sont les plus importantes, un élément conducteur 612b est entouré par un bloc 609b, d'isolation et de réduction de contraintes de hauteur H₂, doté de flancs inclinés selon un angle α₂ par rapport à une normale *̅n̅*̅ au plan principal du support 600, et ayant ainsi une largeur ou dimension critique I₂ mesurée dans une direction parallèle à un plan [O*; i̅ ; k̅*] du repère [O*; i̅ ; j̅ ; k̅*]) variable dans une direction parallèle à la normale *̅n̅*̅.

Dans une autre zone R₁ située au centre de la puce et dans laquelle les contraintes sont plus faibles et où l'on privilégie une plus forte densité d'intégration de composants, un élément conducteur 612a est entouré par un bloc 609a d'isolation et de réduction de contraintes de hauteur H₁ tel que H₁ < H₂, de largeur ou dimension critique I₁ telle que I₁ < I₂ et doté de flancs inclinés selon un angle α₁ tel que α₁ > α₂.

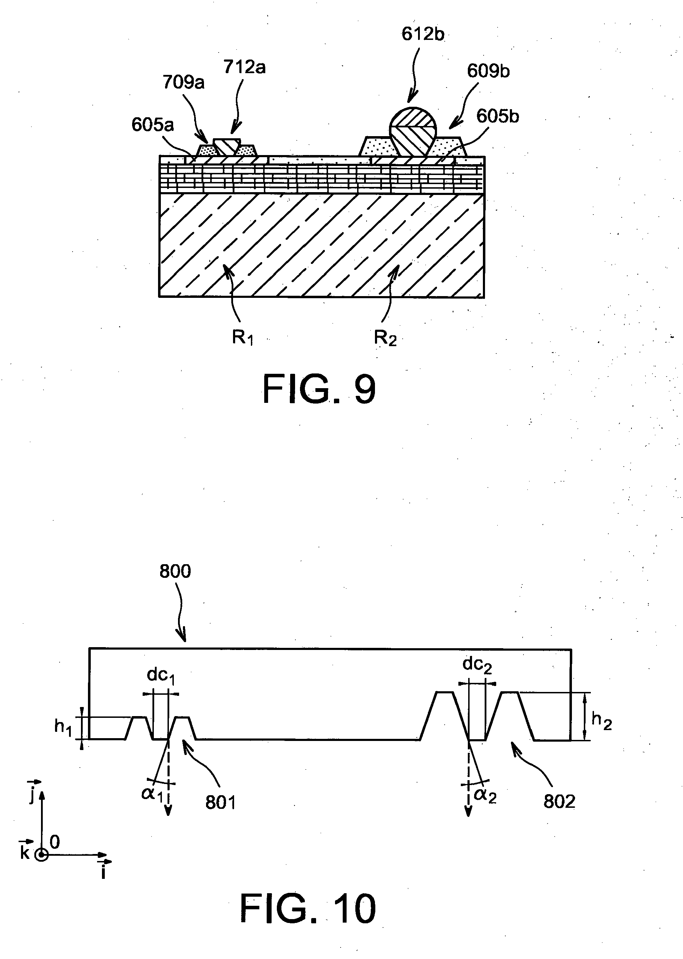

Une autre variante de réalisation est donnée sur la figure 9.

Pour cette variante, des zones conductrices 712a, 612b de types différents sont prévues sur une même face d'un support de type interposeur. Les zones conductrices 712a de plus faible dimension sont destinées à être connectées à un premier type de dispositif, par exemple une carte mère tandis que les zones conductrices 612b de dimensions plus importantes sont entourées de blocs 709a de matériau diélectrique d'épaisseur plus importante destinées à être connectées à un deuxième type de dispositif, par exemple une puce.

Pour réaliser les blocs 609b, 709a de matériau diélectrique, un moule 800 de nano-imprint du type de celui illustré sur la figure 10 peut avoir été utilisé. Ce moule 800 se présente sous forme d'une plaque comportant des motifs 801, 802 faisant saillie sur la plaque et dotés de flancs inclinés par rapport à une normale *̅n̅*̅ au plan principal de la plaque (le plan principal de la plaque étant un plan passant par la plaque et parallèle au plan [O*; i̅ ; k̅* ] du repère [O*; i̅; j̅ ; k̅*] sur la figure 10).

Les motifs 801, 802 du moule 800 ont une section transversale décroissante de leur base vers leur sommet.

Dans cet exemple, la plaque 800 comporte un premier motif 801 de hauteur h₁, de dimension critique dc₁, ainsi qu'un deuxième motif 802 de hauteur h₂ > h₁, de dimension critique dc₂ > dc₁. L'inclinaison des flancs du deuxième motif 802 est également différente de celle des flancs du premier motif 801.

## Revendications

1. Procédé de réalisation d'au moins une reprise de contact comprenant une zone conductrice disposée sur une face d'un support, le procédé comprenant des étapes de :
- retrait d'une épaisseur du support (100) au niveau d'une de ses faces de manière à libérer une extrémité d'un élément conducteur (105a) traversant au moins partiellement l'épaisseur du support (100) et comportant une extrémité affleurant sur cette face ou dépassant de cette face du support,
- formation sur cette face du support (100-103) d'au moins une zone à base de matériau diélectrique (106) sur ledit élément conducteur,
- formation dans ledit matériau diélectrique (106) d'au moins un premier bloc de matériau diélectrique comportant une première cavité dotée de parois inclinées par rapport à une normale au plan principal dudit support et un fond dévoilant ledit élément conducteur (105a, 515), cette étape étant réalisée au moins par application d'un moule d'embossage (200, 300, 400) sur ladite zone de matériau diélectrique (106),
- remplissage de ladite cavité à l'aide d'un matériau conducteur (111) de manière à former une zone conductrice (112a) dans le prolongement dudit élément conducteur.

2. Procédé selon la revendication 1, dans lequel ladite face du support (100-103) comporte au moins une portion d'un deuxième élément conducteur (105b), et dans lequel l'application du moule est réalisée de sorte qu'au moins un deuxième bloc de matériau diélectrique (106) comportant au moins une deuxième cavité (108b) dévoile ledit deuxième élément conducteur.

3. Procédé selon la revendication 2, dans lequel l'application du moule est réalisée de sorte que ledit premier bloc de matériau diélectrique et ledit deuxième bloc de matériau diélectrique appartiennent à une même zone de matériau diélectrique (106) ou sont séparés par un espace vide.

4. Procédé selon la revendication 2 ou 3, dans lequel ladite première cavité (108a) et ladite deuxième cavité (108b) présentent des parties supérieures communicant entre elles.

5. Procédé selon l'une des revendications 2 à 4, dans lequel l'application du moule est réalisée de sorte que ledit premier bloc de matériau diélectrique et ledit deuxième bloc de matériau diélectrique ont des dimensions différentes.

6. Procédé selon l'une des revendications 2 à 5, dans lequel l'application du moule est réalisée de sorte que ledit premier bloc de matériau diélectrique et ledit deuxième bloc de matériau diélectrique présentent des flancs inclinés par rapport à une normale au plan principal dudit support, l'inclinaison des flancs dudit premier bloc étant différente de celle des flancs dudit deuxième bloc.

7. Procédé selon l'une des revendications 1 à 6, dans lequel, entre l'étape de formation du premier bloc comportant la première cavité et l'étape de remplissage de la première cavité on forme une couche de germination sur les parois et le fond de la première cavité, l'étape de remplissage étant réalisée par croissance sur la couche de germination.

8. Procédé selon l'une des revendications 1 à 7, dans lequel le moule d'embossage est sous forme d'un autre support (800) présentant au moins un motif donné (801) faisant saillie sur ledit autre support, le motif donné ayant une section transversale décroissante de sa base vers son sommet et des flancs inclinés.

9. Procédé selon l'une des revendications 1 à 8, dans lequel le moule d'embossage présente au moins un autre motif (802) faisant saillie, cet autre motif comportant des flancs d'inclinaison différente de celle des flancs du motif donné, ou des dimensions différentes de celle du motif donné ou des flancs d'inclinaison différente de celle des flancs du motif donné et des dimensions différentes de celle du motif donné.

## Patentansprüche

1. Verfahren zum Herstellen zumindest einer Kontaktierung, enthaltend einen leitenden Bereich, der auf einer Seite eines Trägers angeordnet ist, wobei das Verfahren die nachfolgenden Schritte umfasst:
- Entfernen einer Schicht des Trägers (100) im Bereich einer seiner Seiten derart, dass ein Ende eines leitenden Elements (105a) freigelegt wird, das sich zumindest teilweise durch die Schicht des Trägers (100) erstreckt, und ein Ende bündig mit dieser Seite liegt oder aus dieser Seite des Trägers vorsteht,
- Bilden zumindest eines Bereichs auf Basis von dielektrischem Material (106) an dem leitenden Element auf dieser Seite des Trägers (100 - 103),
- Bilden zumindest eines ersten Blocks aus dielektrischem Material in dem dielektrischen Material (106), der einen ersten Hohlraum aufweist, der mit gegenüber einer Normalen zur Hauptebene des Trägers geneigt verlaufenden Wänden und mit einem Boden versehen ist, der das leitende Element (105a, 515) aufdeckt, wobei dieser Schritt zumindest durch Anwendung einer Füllform (200, 300, 400) auf diesem Bereich aus dielektrischem Material (106) erfolgt,
- Füllen des Hohlraums mit Hilfe eines leitenden Materials (111), so dass ein leitender Bereich (112a) in Verlängerung des leitenden Elements gebildet wird.

2. Verfahren nach Anspruch 1, wobei die Seite des Trägers (100 - 103) zumindest einen Abschnitt eines zweiten leitenden Elements (105b) enthält und wobei die Anwendung der Füllform so erfolgt, dass zumindest ein zweiter Block aus dielektrischem Material (106) mit zumindest einem zweiten Hohlraum (108b) das zweite leitende Element aufdeckt.

3. Verfahren nach Anspruch 2, wobei die Anwendung der Form so erfolgt, dass der erste Block aus dielektrischem Material und der zweite Block aus dielektrischem Material zu einem gleichen Bereich aus dielektrischem Material (106) gehören oder durch einen Leerraum getrennt sind.

4. Verfahren nach Anspruch 2 oder 3, wobei der erste Hohlraum (108a) und der zweite Hohlraum (108b) obere Teile aufweisen, die miteinander kommunizieren.

5. Verfahren nach einem der Ansprüche 2 bis 4, wobei die Anwendung der Füllform so erfolgt, dass der erste Block aus dielektrischem Material und der zweite Block aus dielektrischem Material unterschiedliche Abmessungen haben.

6. Verfahren nach einem der Ansprüche 2 bis 5, wobei die Anwendung der Füllform so erfolgt, dass der erste Block aus dielektrischem Material und der zweite Block aus dielektrischem Material Flanken aufweisen, die gegenüber einer Normalen zur Hauptebene des Trägers geneigt verlaufen, wobei die Neigung der Flanken des ersten Blocks sich von derjenigen der Flanken des zweiten Blocks unterscheidet.

7. Verfahren nach einem der Ansprüche 1 bis 6, wobei zwischen dem Schritt des Bildens des ersten Blocks mit dem ersten Hohlraum und dem Schritt des Füllens des ersten Hohlraums eine Keimschicht an den Wänden und am Boden des ersten Hohlraums gebildet wird, wobei der Schritt des Füllens durch Wachsen auf der Keimschicht erfolgt.

8. Verfahren nach einem der Ansprüche 1 bis 7, wobei die Füllform in Form eines weiteren Trägers (800) vorliegt, der zumindest ein gegebenes Muster (801) aufweist, das auf den weiteren Träger vorspringt, wobei das gegebene Muster einen von seiner Basis zu seiner Spitze und den geneigten Flanken hin abnehmenden Querschnitt hat.

9. Verfahren nach einem der Ansprüche 1 bis 8, wobei die Füllform zumindest ein weiteres vorspringendes Muster (802) aufweist, wobei dieses weitere Muster Flanken mit einer Neigung aufweist, die sich von derjenigen der Flanken des gegebenen Musters unterscheidet, oder Abmessungen aufweist, die sich von denen des gegebenen Musters unterscheiden, oder Flanken mit einer Neigung aufweist, die sich von derjenigen der Flanken des gegebenen Musters unterscheidet, sowie Abmessungen, die sich von denen des gegebenen Musters unterscheiden.

## Claims

1. A method for making at least one contacting structure comprising a conducting area positioned on one face of a support, the method comprising steps consisting of:
- removing a thickness a support (100) face in order to release one end of a conducting element (105a), said conducting element at least partially crossing the thickness of the support (100) and including an end which is flush on said face or projects beyond from said face of the support,
- forming on said face of the support (100-103), at least one area based on a dielectric material (106) on said conducting element,
- forming in said dielectric materials (106) at least one first block of dielectric material including a first cavity provided with inclined walls relatively to a normal to the main plane of said support and a bottom revealing said conducting element (105a, 515), this step being at least achieved by applying an embossing mold (200, 300, 400) on said area of dielectric material,
- filling said cavity with a conducting material (111) so as to form a conducting area (112a) in the extension of said conducting element.

2. The method according to claim 1, wherein, said face of the support (100-103) includes at least one portion of a second conducting element (105b), and wherein the application of the mold is accomplished so that at least one second block of dielectric material (106) including at least one second cavity (108b) reveals said second conducting element.

3. The method according to claim 2, wherein the application of the mold is carried out so that said first block of dielectric material and said second block of dielectric material (106) belong to a same area of dielectric material or are separated by an empty space.

4. The method according to claim 2 or 3, wherein said first cavity (108a) and said second cavity (108b) have upper portions communicating with each other.

5. The method according to any of the claims 2 to 4, wherein the application of the mold is achieved so that said first block of dielectric material and said second block of dielectric material are of different sizes.

6. The method according to any of the claims 2 to 5, wherein the application of the mold is achieved so that said first block of dielectric material and said second block of dielectric material have inclined flanks relatively to a normal to the main plane of said support, the tilt of the flanks of said first block being different from that of the flanks of said second block.

7. The method according to any of the claims 1 to 6, wherein, between the step for forming the first block including the first cavity and the step for filling the first cavity, a germination layer is formed on the walls and the bottom of the first cavity, the filling step being achieved by growth on the germination layer.

8. The method according to any of the claims 1 to 7, wherein the embossing mold is in the form of another support (800) having at least one given pattern (801) protruding on said other support, said given pattern having a cross-section increasing from its base to its top and inclined flanks.

9. The method according to any of the claims 1 to 8, wherein the embossing mold has at least one other protruding pattern (802), this other pattern including flanks with a different tilt from that of the flanks of said given pattern, or with dimensions different from that of said given pattern or with flanks of a tilt different from the one of the flanks of said given pattern and with dimensions different from those of said given pattern.
